(19) Europäisches Patentamt
European Patent Office
Office européen des brevets

(11) EP 3 889 698 A1

(12) EUROPEAN PATENT APPLICATION

(43) Date of publication:
06.10.2021 Bulletin 2021/40

(51) Int Cl.:
*G05B 17/02* (2006.01)      *G06F 30/00* (2020.01)
*G06Q 50/06* (2012.01)

(21) Application number: 20166725.0

(22) Date of filing: 30.03.2020

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Aktiengesellschaft 80333 München (DE)**

(72) Inventors:
• **Mesanovic, Amer**
  **80992 München (DE)**
• **Szabo, Andrei**
  **85521 Ottobrunn (DE)**
• **Bamberger, Joachim**
  **82131 Stockdorf (DE)**
• **Ackermann, Simon**
  **80798 München (DE)**
• **Löw, Stefan**
  **95698 Neualbenreuth (DE)**
• **Mayer, Peter**
  **81739 München (DE)**

(54) **METHOD, COMPUTER-IMPLEMENTED TOOL AND POWER PLANT CONTROL DEVICE FOR DETERMINING A PERFORMANCE OF A HYBRID POWER PLANT AND HYBRID POWER PLANT SYSTEM**

(57)    In order to determine a performance of a hybrid power plant ($HPP_x$), by which the performance determination is automated it is proposed to determine a performance of the hybrid power plant, which is comparable to numerous reference hybrid power plants ($HPP_{r,1}$, $HPP_{r,2}$,... $HPP_{r,L}$) already being in operation and which is either also in operation or at least one of designed, deployed and commissioned for operation by
- calculating operation-related key performance indicators ($KPI_o$) for each reference hybrid power plant ($HPP_{r,1}$, $HPP_{r,2}$, ... $HPP_{r,L}$),
- storing for the reference hybrid power plants sets of the calculated, operation-related key performance indicators ($\underline{KPI_{o,1}}$, $\underline{KPI_{o,2}}$, ... $\underline{KPI_{o,L}}$)
- determining a-priori key performance indicators ($KPI_a$) for each reference hybrid power plant and for the hybrid power plant,
- storing for the reference hybrid power plants and the hybrid power plant a-priori key performance indicators ($\underline{KPI_{a,1}}$, $\underline{KPI_{a,2}}$,... $\underline{KPI_{a,L}}$, $\underline{KPI_{a,x}}$),
- inputting the a priori-key performance indicators and the operation-related key performance indicators to a calculation engine (CE) to predict or to estimate at least one operation-related key performance indicator ($KPI_{o,x}$),
- training a mapping function ($f_m$) with the inputted KPI-sets by the calculation engine such that the result of the training is the operation-related key performance indicator,
- deriving from the operation-related key performance indicator a performance size (PS) or performance value (PV) of the hybrid power plant ($HPP_x$).

FIG 1

**Description**

The invention refers to a method for determining a performance of a hybrid power plant according to the preamble of claim 1, a computer-implemented tool for determining a performance of a hybrid power plant according to the preamble of claim 6, a power plant control device for determining a performance of a hybrid power plant according to the preamble of claim 11 and a hybrid power plant system according to the preamble of claim 12.

Hybrid electric power plants - hereinafter referred to as hybrid power plants - are constructed and built around the world in various operating conditions. The hybrid power plants consist for instance of photovoltaic generators, diesel gensets, batteries, wind turbines etc. According to new business models it is required to issue performance guarantees when constructing and building such hybrid power plants.

These guarantees include inter alia the availability of the hybrid power plant or the price of produced electric energy. The guarantees are based on forecasts and assumptions during the project planning phase. The problem is that these guarantees are currently too conservative, as they are based on conservative assumptions and forecasts.

Making less-conservative guarantees would increase the competitiveness of hybrid power plant providers and increase the number of new projects. The invention hereinafter disclosed is offering a solution approach to avoid that.

Guarantees being made according to the state-of-the-art use also conservative forecasts and assumptions, which are fed into a simulation software for power system simulation.

Typically, for the renewable generation components, multiannual weather data is used to compute the expected production. It is common that the weather data is computed using a statistical approach, i.e. P50 or P90. The result of the computation is an energy yield prediction in terms of an annual energy production (AEP), which is called P50. The probability of reaching a higher or lower annual energy production is 50:50. A risk assessment includes the quantification of the project specific uncertainties and the whole range of exceedance probabilities (Pxx) of the power generator's annual energy production. So, P90 is the annual energy production which is reached with a probability of 90% (cf.https://www.dewi.de/dewi/fileadmin/pdf/publications/Magaz in 28/07.pdf).

State-of-the-art is also that there are databases for different components containing statistics for component performance, e.g. efficiency, and operation statistics, e.g. failure rate. This is common in particular for gas turbines.

However, it is more difficult to predict the performance of power plant components when they are combined into a hybrid power plant, as the interaction of these components impacts their performance.

For example, if a diesel generator is combined with photovoltaic generation, there will be more starts and stops due to the volatility of the photovoltaic generation, which reduces its overall lifetime. The prediction of the performance of such systems is not handled today with systematic approaches, but typically conservative assumptions are made to compensate for this unknown interaction.

It is an objective of the invention to propose a method, computer-implemented tool and control device for determining a performance of a hybrid power plant as well as a hybrid power plant, by which the performance determination is automated.

This objective is solved based on a method defined in the preamble of claim 1 by the features in the characterizing part of claim 1.

The objective is further solved based on a computer-implemented tool defined in the preamble of claim 6 by the features in the characterizing part of claim 6.

The objective is solved furthermore based on a power plant control device defined in the preamble of claim 11 by the features in the characterizing part of claim 11.

The objective is solved moreover based on a hybrid power plant system defined in the preamble of claim 12 by the features in the characterizing part of claim 12.

The main idea of the invention according to the claims 1, 6, 11 and 12 is to determine a performance of a hybrid power plant, which is comparable to numerous reference hybrid power plants already being in operation and which is either also in operation or at least one of designed, deployed and commissioned for operation by

- calculating operation-related key performance indicators for each reference hybrid power plant,
- storing for the reference hybrid power plants sets of the calculated, operation-related key performance indicators,
- determining a-priori key performance indicators for each reference hybrid power plant and for the hybrid power plant,
- storing for the reference hybrid power plants and the hybrid power plant a-priori key performance indicators,
- inputting the determined, a priori-key performance indicators and the calculated, operation-related key performance indicators to a calculation engine to predict or to estimate at least one operation-related key performance indicator,
- training a mapping function with the inputted KPI-sets as arguments of the mapping function by the calculation engine such that the result of the training is the at least one predieted or estimated operation related key performance indicator,
- deriving from the at least one predicted or estimated operation-related key performance indicator a performance size or performance value of the hybrid power plant.

In other simple words the idea of the invention is to estimate the at least one operation-related key performance indicator for the hybrid power plant being for instance in planning phase using a priori-key performance indicators obtained a-priori for the plant and a database of a priori-key performance indicators and operation-related key performance indicators of reference hybrid power plants being already existent.

Following this idea of the invention guarantees for hybrid power plants, consisting of multiple heterogeneous generation units, can determined or calculated automatically by using operational data from reference hybrid power plants.

The determination of guarantees for hybrid power plants can be advantageously achieved via the derived performance size or performance value, when they are used to assess the hybrid power plant by a parameter according to claims 5 and 10.

Alternatively, according to these claims it is also possible to apply a setpoint to the hybrid power plant, if the plant as the reference hybrid power plants is already in operation.

One aspect of the proposed solution is that the performance of a new hybrid power plant can be estimated or predicted, based on information in a database of existing reference hybrid power plants located in different geographical areas and with different operating conditions.

This is illustrated in more detail on the following hypothetical example:
It is planned to build a new hybrid power plant in Galapagos, consisting of photovoltaic generation and diesel generators. During the design phase for the power plant, key performance indicators (KPI's) of the hybrid power plant must be specified in order to calculate a performance guarantee.

It is further assumed that there exist already information or measurement data from another hybrid power plant in the Galapagos Islands, the said reference hybrid power plants, which consists, however, only of diesel gensets from another manufacturer.

Furthermore, it is assumed that there exist already information or measurement data from a hybrid power plant with photovoltaic generation and diesel generators in South Africa, which also has gensets from the same manufacturer. The question remains how should the KPI's of these reference hybrid power plants be combined in order to predict at least one KPI of the new hybrid power plant.

This present invention proposes a solution to this problem and the solution makes it possible to make more accurate assumptions during a project acquisition phase of a new hybrid power plant. This makes the overall offer for constructing and building a new hybrid power plant more attractive to customers and reduces the risk of guarantee violation.

According to the state-of-the-art cited above the solution proposes a systematic approach for computing KPI's for a new hybrid power plant under planning by training a mapping or extrapolation function based on KPI's of reference hybrid power plants still existing, which are preferably stored in a database.

In the state-of-the-art, this mapping or extrapolation is done with expert knowledge, i.e. a design engineer summarizes the KPI's and combines them according to his expertise.

The solution outlined above proposes to make an automated mapping function (e.g. polynomial mapping or neural networks) and to train this mapping using stored information, e.g. in the database. The training is done by minimizing an error between the result of the mapping based on N-1 plants and the KPI's of the remaining plant, this error being minimized over all the plants combinations.

The resulting mapping is then applied to the inputs for the new plant, which is being designed, to determine the expected KPI's and guarantee information. In this way it is possible that less-conservative guarantees to customers can be offered, which will increase the number of new projects, and the risk of guarantee violation is reduced.

For the purpose of performing the automated mapping or extrapolation of KPI's from existing hybrid power plants to estimate at least one KPI of the new power plant preferably either a weighted average according to claims 2 and 7 or a machine learning according to claims 3 and 8 is used.

By calculating the weighted average of the KPI's of reference hybrid power plants, where KPI's of power plants with different weather conditions are weighted less. Furthermore, geographic conditions are considered in the weighting process, as they have an impact on maintenance times and breakdowns.

Machine learning can also be used, where measurements from plants are used for the machine learning process.

Finally, it is advantageous to reduce the number of the inputted KPI-sets by selecting a subset of the stored KPI-sets of those reference hybrid power plants, which match best with or are similar to the hybrid power plant according to the claims 4 and 9. By this measure the computing effort in the calculation engine can be reduced.

Moreover, advantageous further developments of the invention arise out of the following description of a preferred embodiment of the invention according to FIGURES 1 to 5. They show:

FIGURE 1 a hybrid power plant system for determining a performance of a hybrid power plant as an "implementation-concept",

FIGURE 2 a hybrid power plant system for determining a performance of a hybrid power plant as a "functional-unitconcept",

FIGURE 3 a flow chart for determining a performance of a hybrid power plant,

FIGURE 4 a principle diagram of a calculating engine as a component in the context of the performance determination,

FIGURE 5 a mode of operation of a "key performance indicator"-generator as a component in the context of the performance determination.

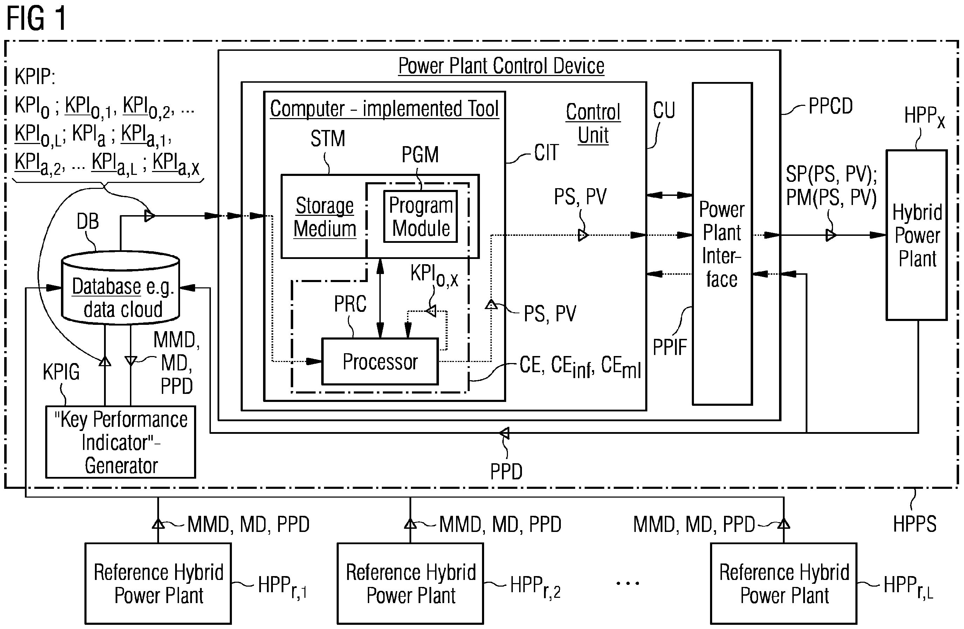

FIGURE 1 shows a hybrid power plant system HPPS for determining a performance of a hybrid power plant $HPP_x$ as an "implementation-concept".

According to this depiction the hybrid power plant system HPPS includes, besides the hybrid power plant $HPP_x$, as a central component for controlling and managing purposes with regard to the storage, provision and delivery of electrical energy by the hybrid power plant $HPP_x$ a power plant control device PPCD as well as moreover a database DB, which is preferably designed as a data cloud, and a "key performance indicator"-generator KPIG. To implement the cited purposes the power plant control device PPCD includes a control unit CU and a power plant interface PPIF, wherein the corresponding control of the hybrid power plant $HPP_x$ is carried out by the control unit CU via the power plant interface PPIF.

Furthermore in the context of the determining task of the hybrid power plant system HPPS the power plant control device PPCD with the cited two components, the control unit CU and the power plant interface PPIF, is also responsible for determining the performance of the hybrid power plant $HPP_x$. Therefor according to the "implementation-concept" depicted in the FIGURE 1 the control unit CU includes a computer-implemented tool CIT which is implemented as a sub-unit in the control unit BMU. The computer-implemented tool CIT is a computer-program-product which is preferably designed as an application software, called as APP, that allows, when it is implemented, to perform special tasks. So, in the present case of the control unit CU, where the computer-program-product respectively the APP is implemented, the computer-implemented tool CIT is used for determining the performance of the hybrid power plant $HPP_x$.

To this end the computer-implemented tool CIT comprises a non-transitory, processor-readable storage medium STM, in which processor-readable program-instructions of a program module PGM are stored. This program module PGM is used for determining the performance of the hybrid power plant $HPP_x$. Moreover the computer-implemented tool CIT comprises a processor PRC connected with the storage medium STM executing the processor-readable program-instructions of the program module PGM to determine the hybrid power plant performance, wherein the program module PGM and the processor PRC form a calculation engine CE for doing this determination.

The determination is generally based on key performance indicator provisions KPIP, which however are carried out independently from the performance determination process itself. To do this performance determination of the hybrid power plant $HPP_x$ it is considered that the hybrid power plant $HPP_x$ is comparable to a number L of reference hybrid power plants $HPP_{r,1}$, $HPP_{r,2}$,... $HPP_{r,L}$. These reference hybrid power plants $HPP_{r,1}$, $HPP_{r,2}$,... $HPP_{r,L}$ are already being in operation, wherein the hybrid power plant $HPP_x$ is either also in operation or at least one of designed, deployed and commissioned for operation.

With reference to these comparison-based key performance indicator provisions KPIP for each reference hybrid power plant of the L reference hybrid power plants $HPP_{r,1}$, $HPP_{r,2}$,... $HPP_{r,L}$ operation-related key performance indicators $KPI_o$ are calculated as a first type of key performance indicator. This calculation of the operation-related key performance indicators $KPI_o$ is based either on measurement data MMD or alternatively on the measurement data MMD and metadata MD of these measurement data MMD and in each case of each power plant of the L reference hybrid power plants $HPP_{r,1}$, $HPP_{r,2}$,... $HPP_{r,L}$. This calculation happens such that each reference hybrid power plants $HPP_{r,1}$, $HPP_{r,2}$,... $HPP_{r,L}$ supplies the measurement data MMD or the measurement data MMD and the metadata MD to the database DB and the "key performance indicator"-generator KPIG accesses the data MMD, MD stored in the database DB. So, the "key performance indicator"-generator KPIG generates by calculating for a first reference hybrid power plant $HPP_{r,1}$ a first set of operation-related key performance indicators $\underline{KPI}_{o,1}$, for a second reference hybrid power plant $HPP_{r,2}$ a second set of operation-related key performance indicators $\underline{KPI}_{o,2}$, etc. and for a L-th reference hybrid power plant $HPP_{r,L}$ a L-th set of operation-related key performance indicators $\underline{KPI}_{o,L}$. All the sets of calculated, operation-related key performance indicators $\underline{KPI}_{o,1}$, $\underline{KPI}_{o,2}$... $\underline{KPI}_{o,L}$ are stored in the database DB, wherein each set of the calculated, operation-related key performance indicators $\underline{KPI}_{o,1}$, $\underline{KPI}_{o,2}$... $\underline{KPI}_{o,L}$ contains a number Y of operation-related key performance indicators $KPI_o$ with $1 \leq Y \leq n$ and $n \in \mathbb{N}$.

Furthermore, with reference to the cited comparison-based key performance indicator provisions KPIP for each reference hybrid power plant of the L reference hybrid power plants $HPP_{r,1}$, $HPP_{r,2}$,... $HPP_{r,L}$ and the hybrid power plant

$HPP_x$ a-priori key performance indicators $KPI_a$ are determined as a second type of key performance indicator. This determination of the a-priori key performance indicators $KPI_a$ is based each on power plant data PPD related to at least one of plant environment, plant structure, power plant attributes and plant components. This determination happens such that each reference hybrid power plants $HPP_{r,1}$, $HPP_{r,2}$,... $HPP_{r,L}$ and the hybrid power plant $HPP_x$ supply the power plant data PPD to the database DB and the "key performance indicator"-generator KPIG accesses the data PPD stored in the database DB. So, the "key performance indicator"-generator KPIG generates by determining for the first reference hybrid power plant $HPP_{r,1}$ a first set of a-priori key performance indicators $\underline{KPI}_{a,1}$, for the second reference hybrid power plant $HPP_{r,2}$ a second set of a-priori key performance indicators $\underline{KPI}_{a,2}$, etc. and for the L-th reference hybrid power plant $HPP_{r,L}$ a L-th set of a-priori key performance indicators $\underline{KPI}_{a,L}$ as well as for the hybrid power plant $HPP_x$ a set of determined, a-priori key performance indicators $\underline{KPI}_{a,x}$. All the sets of determined, a-priori key performance indicators $\underline{KPI}_{a,1}$, $\underline{KPI}_{a,2}$... $\underline{KPI}_{a,L}$, $\underline{KPI}_{a,x}$ are stored in the database DB, wherein each set of the determined, a-priori key performance indicators $\underline{KPI}_{o,1}$, $KPI_{o,2}$... $\underline{KPI}_{o,L}$, $KPI_{a,x}$ contains a number Z of a-priori key performance indicators $KPI_a$ with $1 \leq Z \leq n$ and $n\epsilon N$.

The statements outlined above define two types of KPI's, depending if they are a-priori available for the hybrid power plant or if they are calculated out of data collected from a running hybrid power plant:
A-priori key performance indicators are for example typically related with the plant environment and plant structure. These are available before a plant is installed. These KPI's can be obtained for example during the plant planning.

The plant structure consists of which components are installed and from which manufacturers, e.g. a single line diagram of the plant.

Environment key performance indicators are for example the irradiation or wind speed statistics, which are typically available from weather services, geographical and infrastructure information which influence service times, they are KPI's which can be obtained from components technical data sheets, e.g. efficiency and losses.

Operation-related key performance indicators are for example computed out of the operation data from the plant using historical data. These KPI's can be computed only after the plant is installed and running.

For doing now the cited determination the performance of the hybrid power plant $HPP_x$ the calculation engine CE formed by the processor PRC and the program module PGM

(1) predicts or estimates at least one operation-related key performance indicator $KPI_{o,x}$, when the stored sets of determined, a priori-key performance indicators $\underline{KPI}_{a,1}$, $\underline{KPI}_{a,2}$... $\underline{KPI}_{a,L}$, $\underline{KPI}_{a,x}$ and the stored sets of calculated, operation-related key performance indicators $\underline{KPI}_{o,1}$, $\underline{KPI}_{o,2}$... $\underline{KPI}_{o,L}$ are inputted into the calculation engine CE, preferably for instance when the calculation engine CE respectively the processor PRC accesses the database DB,
(2) predicts or estimates the at least one operation-related key performance indicator ($KPI_{o,x}$) by training a mapping function $f_m$ with the inputted KPI-sets $\underline{KPI}_{a,1}$, $\underline{KPI}_{a,2}$... $\underline{KPI}_{a,L}$, $\underline{KPI}_{a,x}$, $\underline{KPI}_{o,1}$, $\underline{KPI}_{o,2}$... $\underline{KPI}_{o,L}$ as arguments of the mapping function $f_m$,
(3) derives a performance size PS or performance value PV of the hybrid power plant $HPP_x$ from the at least one predicted or estimated operation-related key performance indicator $KPI_{o,x}$.

The calculation engine CE is designed preferably as an inference calculation engine $CE_{inf}$ to predict the at least one operation-related key performance indicator $KPI_{o,x}$ by training a linear analytical inference function

$f_{inf,KPI_{o,x,y}}$
for a y-th operation-related $KPI_{o,x,y}$ for each of the Y operation-related key performance indicators $KPI_o$

$$f_{inf,KPI_{o,x,y}}\left(KPI_{a,1}, KPI_{a,2}, \ldots KPI_{a,L}, KPI_{a,x}, KPI_{o,1}, KPI_{o,2}, \ldots KPI_{o,L},\right) = \sum_{i=1}^{L}\sum_{j=1}^{Y}\sum_{k=1}^{Z} a_{yjk} e^{-\left(KPI_{a,i,k}-KPI_{a,x,k}\right)^2} KPI_{o,i,j}$$

wherein

- $a_{yjk}$ are parameters of the linear analytical inference function $f_{inf,KPI_{o,x,y}}$,
- to train the linear analytical inference function $f_{inf,KPI_{o,x,y}}$ state of the art solvers is used to minimize the deviation between the predicted $KPI_{o,x,y}$, and the measured ones,
- a number L-1 of the stored, reference hybrid power plants $HPP_{r,1}$, $HPP_{r,2}$,... $HPP_{r,L}$ are used as inputs,
- from the remaining L-th plant of the stored, reference hybrid power plants $HPP_{r,1}$, $HPP_{r,2}$,... $HPP_{r,L}$ an a-priori key performance indicator $KPI_{a,L}$ is used as input and an operation-related key performance indicator $KPI_{o,L,y}$ as expected value,
- a difference is defined as

$$\text{err}_{\text{KPI}_{o,L,y}} = \text{KPI}_{o,L,y} - f_{\text{inf},\text{KPI}_{o,L,y}}\left(\text{KPI}_{a,1}, \text{KPI}_{a,2}, \ldots \text{KPI}_{a,L}, \text{KPI}_{o,1}, \text{KPI}_{o,2}, \ldots \text{KPI}_{o,L-1}\right)$$

- an optimization problem is solved to estimate the parameters $a_{yjk}$ for the y-th operation-related key performance $\text{KPI}_{o,L,y}$

$$\underset{a_{yjk}}{\text{argmin}} \sum_{n=1}^{N} (\text{err}_{\text{KPI}_{o,L,y)}})2$$

- the same procedure is repeated to estimate $a_{yjk}$ for all operation-related key performance indicators $\text{KPI}_{o}$.

Alternatively the calculation engine CE can be designed as an machine-learning calculation engine $\text{CE}_{\text{ml}}$ to estimate the at least one operation-related key performance indicator $\text{KPI}_{o,x}$ by training the mapping function $f_m$ without the need to specify a structure of the mapping function $f_m$, wherein a subset of the reference hybrid power plants $\text{HPP}_{r,1}$, $\text{HPP}_{r,2}$,... $\text{HPP}_{r,L}$ are used for the training, while the remaining ones of the reference hybrid power plants $\text{HPP}_{r,1}$, $\text{HPP}_{r,2}$,... $\text{HPP}_{r,L}$ are used for validation.

Moreover, for extending the cited performance determination of the hybrid power plant $\text{HPP}_x$ the performance size PS or the performance value PV of the hybrid power plant $\text{HPP}_x$ is used advantageously to apply a setpoint SP to the hybrid power plant $\text{HPP}_x$ or is used to assess the hybrid power plant $\text{HPP}_x$ by a parameter PM.

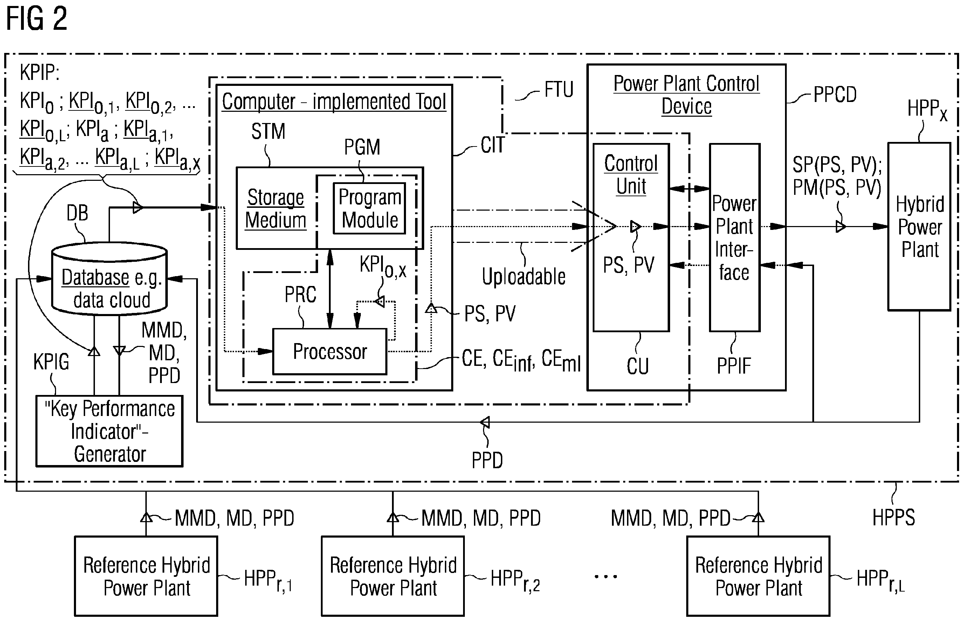

FIGURE 2 shows a hybrid power plant system HPPS for determining a performance of a hybrid power plant $\text{HPP}_x$ as a "functional-unit-concept".

Also according to this depiction the hybrid power plant system HPPS includes, besides the hybrid power plant $\text{HPP}_x$, as a central component for controlling and managing purposes with regard to the storage, provision and delivery of electrical energy by the hybrid power plant $\text{HPP}_x$ the power plant control device PPCD as well as moreover the database DB, which is preferably designed again as the data cloud, and the "key performance indicator"-generator KPIG. To implement the cited purposes the power plant control device PPCD includes again the control unit CU and the power plant interface PPIF, wherein the corresponding control of the hybrid power plant $\text{HPP}_x$ is carried out by the control unit CU via the power plant interface PPIF.

In the context of the determining task of the hybrid power plant system HPPS the power plant control device PPCD with the cited two components, the control unit CU and the power plant interface PPIF, is now - in contrast to the power plant control device PPCD depicted in the FIGURE 1 - not directly responsible for determining the performance of the hybrid power plant $\text{HPP}_x$. Therefor according to the "functional-unitconcept" depicted in the FIGURE 2 the control unit CU does not include the computer-implemented tool CIT. Instead, the Computer-implemented tool CIT forms a functional unit FTU with the control unit CU. This functional unit FTU is preferably designed such that the Computer-implemented tool CIT is either uploadable into the control unit CU according to the depiction in the FIGURE 2 or forms either (not depicted in the FIGURE 2) a cloud-based, centralized platform, e.g. a server, for the power plant control device PPCD or a decentralized platform, e.g. a server, for the power plant control device PPCD with a mutual access within the functional unit between the control unit CU and the Computer-implemented tool CIT.

In each of cited variants of realization the computer-implemented tool CIT is again a computer-program-product which in the case upload-functionality is again preferably designed as an application software, called as APP, that allows, when it is implemented, to perform special tasks. So, in the present case of the control unit CU, when the computer-program-product respectively the APP is uploaded, the power plant control device PPCD with uploaded computer-implemented tool CIT is used for determining the performance of the hybrid power plant $\text{HPP}_x$.

To this end the computer-implemented tool CIT comprises again the non-transitory, processor-readable storage medium STM, in which processor-readable program-instructions of the program module PGM are stored. This program module PGM is used again for determining the performance of the hybrid power plant $\text{HPP}_x$. Moreover the computer-implemented tool CIT comprises again the processor PRC connected with the storage medium STM executing the processor-readable program-instructions of the program module PGM to determine the hybrid power plant performance, wherein the program module PGM and the processor PRC form again the calculation engine CE for doing this determination.

The determination is again generally based on the key performance indicator provisions KPIP, which however are carried out again independently from the performance determination process itself. To do this performance determination of the hybrid power plant $\text{HPP}_x$ it is considered again that the hybrid power plant $\text{HPP}_x$ is comparable to the number L of reference hybrid power plants $\text{HPP}_{r,1}$, $\text{HPP}_{r,2}$,... $\text{HPP}_{r,L}$. These reference hybrid power plants $\text{HPP}_{r,1}$, $\text{HPP}_{r,2}$,... $\text{HPP}_{r,L}$ again are already being in operation, wherein the hybrid power plant $\text{HPP}_x$ is either also in operation or at least one of designed, deployed and commissioned for operation.

Again with reference to these comparison-based key performance indicator provisions KPIP for each reference hybrid power plant of the L reference hybrid power plants $HPP_{r,1}$, $HPP_{r,2}$,... $HPP_{r,L}$ the operation-related key performance indicators $KPI_o$ are calculated as the first type of key performance indicator. This calculation of the operation-related key performance indicators $KPI_o$ is based again either on the measurement data MMD or alternatively on the measurement data MMD and the metadata MD of these measurement data MMD and in each case of each power plant of the L reference hybrid power plants $HPP_{r,1}$, $HPP_{r,2}$,... $HPP_{r,L}$. This calculation happens again such that each reference hybrid power plants $HPP_{r,1}$, $HPP_{r,2}$,... $HPP_{r,L}$ supplies the measurement data MMD or the measurement data MMD and the metadata MD to the database DB and the "key performance indicator"-generator KPIG again accesses the data MMD, MD stored in the database DB. So, the "key performance indicator"-generator KPIG generates again by calculating for the first reference hybrid power plant $HPP_{r,1}$ the first set of operation-related key performance indicators $\underline{KPI}_{o,1}$, for the second reference hybrid power plant $HPP_{r,2}$ the second set of operation-related key performance indicators $\underline{KPI}_{o,2}$, etc. and for the L-th reference hybrid power plant $HPP_{r,L}$ the L-th set of operation-related key performance indicators $\underline{KPI}_{o,L}$. All the sets of calculated, operation-related key performance indicators $\underline{KPI}_{o,1}$, $\underline{KPI}_{o,2}$... $\underline{KPI}_{o,L}$ are stored again in the database DB, wherein each set of the calculated, operation-related key performance indicators $\underline{KPI}_{o,1}$, $\underline{KPI}_{o,2}$... $\underline{KPI}_{o,L}$ contains again the number Y of operation-related key performance indicators $KPI_o$ with $1 \leq Y \leq n$ and $n \epsilon N$.

Furthermore and again, with reference to the cited comparison-based key performance indicator provisions KPIP for each reference hybrid power plant of the L reference hybrid power plants $HPP_{r,1}$, $HPP_{r,2}$,... $HPP_{r,L}$ and the hybrid power plant $HPP_x$ the a-priori key performance indicators $KPI_a$ are determined as the second type of key performance indicator. This determination of the a-priori key performance indicators $KPI_a$ is based again each on the power plant data PPD related to the at least one of plant environment, plant structure, power plant attributes and plant components. This determination happens again such that each reference hybrid power plants $HPP_{r,1}$, $HPP_{r,2}$,... $HPP_{r,L}$ and the hybrid power plant $HPP_x$ supply the power plant data PPD to the database DB and the "key performance indicator"-generator KPIG accesses the data PPD stored in the database DB. So, the "key performance indicator"-generator KPIG generates again by determining for the first reference hybrid power plant $HPP_{r,1}$ the first set of a-priori key performance indicators $\underline{KPI}_{a,1}$, for the second reference hybrid power plant $HPP_{r,2}$ the second set of a-priori key performance indicators $\underline{KPI}_{a,2}$, etc. and for the L-th reference hybrid power plant $HPP_{r,L}$ the L-th set of a-priori key performance indicators $\underline{KPI}_{a,L}$ as well as for the hybrid power plant $HPP_x$ the set of a-priori key performance indicators $\underline{KPI}_{a,x}$. All the sets of determined, a-priori key performance indicators $\underline{KPI}_{a,1}$, $\underline{KPI}_{a,2}$... $\underline{KPI}_{a,L}$, $\underline{KPI}_{a,x}$ are stored again in the database DB, wherein each set of the determined, a-priori key performance indicators $\underline{KPI}_{o,1}$, $\underline{KPI}_{o,2}$... $\underline{KPI}_{o,L}$, $\underline{KPI}_{a,x}$ contains again the number Z of a-priori key performance indicators $KPI_a$ with $1 \leq Z \leq n$ and $n \epsilon N$.

For doing now the cited determination the performance of the hybrid power plant $HPP_x$ the calculation engine CE formed by the processor PRC and the program module PGM

(1) predicts or estimates again the at least one operation-related key performance indicator $KPI_{o,x}$, when the stored sets of determined, a priori-key performance indicators $\underline{KPI}_{a,1}$, $\underline{KPI}_{a,2}$... $\underline{KPI}_{a,L}$, $\underline{KPI}_{a,x}$ and the stored sets of calculated, operation-related key performance indicators $\underline{KPI}_{o,1}$, $\underline{KPI}_{o,2}$... $\underline{KPI}_{o,L}$ are inputted into the calculation engine CE, preferably for instance when the calculation engine CE respectively the processor PRC accesses again the database DB,

(2) predicts or estimates again the at least one operation-related key performance indicator ($KPI_{o,x}$) by training the mapping function $f_m$ with the inputted KPI-sets $\underline{KPI}_{a,1}$, $\underline{KPI}_{a,2}$... $\underline{KPI}_{a,L}$, $\underline{KPI}_{a,x}$, $\underline{KPI}_{o,1}$, $\underline{KPI}_{o,2}$... $\underline{KPI}_{o,L}$ as arguments of the mapping function $f_m$,

(3) derives again the performance size PS or the performance value PV of the hybrid power plant $HPP_x$ from the at least one predicted or estimated operation-related key performance indicator $KPI_{o,x}$.

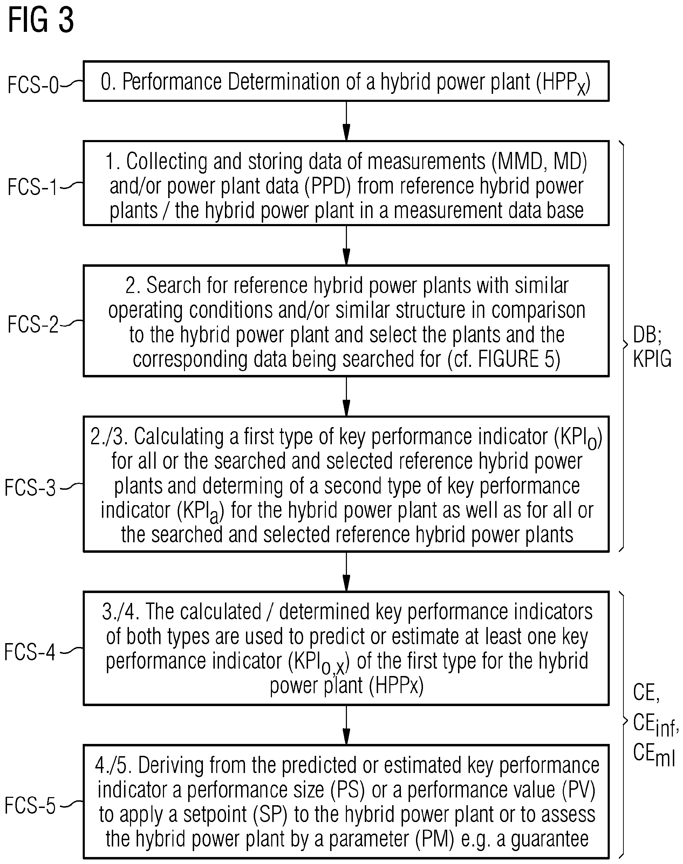

FIGURE 3 a flow chart of a process for determining a performance of the hybrid power plant $HPP_x$ being initiated in a flow-chart-state FCS-0 and summarizing the entire determining process according to the description of the FIGURES 1, 2 and 5.

The process starts with that in a first flow-chart-state FCS-1 (process step 1.) at least one of data of measurements MMD, MD and power plant data PPD from the reference hybrid power plants $HPP_{r,1}$, $HPP_{r,2}$,... $HPP_{r,L}$ or the reference hybrid power plants $HPP_{r,1}$, $HPP_{r,2}$,... $HPP_{r,L}$ and the hybrid power plant $HPP_x$ are collected and stored in the database DB.

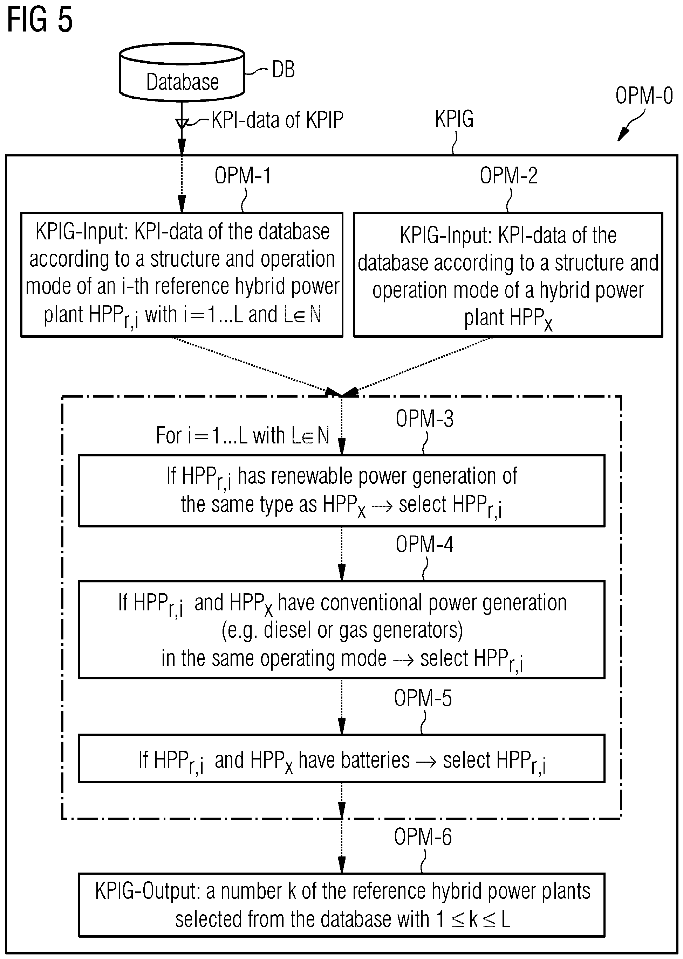

In a following second flow-chart-state FCS-2 (process step 2.) and based on the data MMD, MD, PPD stored in the database DB it is searched for distinct reference hybrid power plants of the reference hybrid power plants $HPP_{r,1}$, $HPP_{r,2}$,... $HPP_{r,L}$ with at least one of similar operating conditions and similar structure in comparison to the hybrid power plant $HPP_x$ and it is selected the plants and the corresponding data being searched for. This approach for determining the performance of the hybrid power plant $HPP_x$ is optional and is described in more detail in FIGURE 5. However, it means also that the process, started in the first flow-chart-state FCS-1, is continued normally with a third flow-chart-state FCS-3 (process step 2./3.).

In the third flow-chart-state FCS-3 it is calculated the first type of key performance indicator $KPI_o$ for all the reference hybrid power plants $HPP_{r,1}$, $HPP_{r,2}$,... $HPP_{r,L}$ or for the searched and selected reference hybrid power plants and it is determined the second type of key performance indicator $KPI_a$ for the hybrid power plant $HPP_x$ as well as for all the reference hybrid power plants $HPP_{r,1}$, $HPP_{r,2}$,... $HPP_{r,L}$ or for the searched and selected reference hybrid power plants.

So, by using the collected and stored data respectively the searched and selected data, relevant key performance indicators (KPI's) are calculated for components of each hybrid power plant. For example:

1. The following KPI's are calculated for renewable generation:

- Ratio between simulated and measured production of electric energy - indicating the performance of the control system.
- Irradiation/wind speed measurements for several years are saved for later use in a simulation tool.

2. The following KPI's are calculated for gensets:

- Total produced AC electrical energy and total amount of starts of a genset before it was replaced.
- The ratio between the data sheet fuel consumption and the measured fuel consumption is calculated, as well as the increase of consumption until the genset was replaced.
- A histogram of the AC power of the genset is calculated, showing the percentage of time the genset was operated in different power ranges.

3. The following KPI's are calculated for all batteries:

- Time until a state-of-health (SOH) of the battery started to rapidly drop.
- Average daily throughput of the battery.
- Average number of daily cycles of the battery.

Moreover and preferably for each component a mean time to failure and mean time to repair is also calculated. If data for the evaluation of one or more KPI's is not available, the evaluation of these KPI's is skipped.

The actions of the two respectively three flow-chart-states FCS-1, FSC-2, FCS-3 are related to the involvement of the database DB and the "key performance indicator"-generator KPIG as indicated in the FIGURE 3.

In a subsequent fourth flow-chart-state FCS-4 (process step 3./4.) the calculated respectively determined key performance indicators of both types are used to predict or estimate the at least one key performance indicator $KPI_{o,x}$ for the hybrid power plant $HPP_x$.

Finally, in a following fifth flow-chart-state FCS-5 (process step 4./5.) the performance size PS or the performance value PV of the hybrid power plant $HPP_x$ is derived from the at least one predicted or estimated operation-related key performance indicator $KPI_{o,x}$ to apply the setpoint SP to the hybrid power plant $HPP_x$ or to assess the hybrid power plant $HPP_x$ by the parameter PM, e.g. a guarantee.

The actions from the fourth flow-chart-state FCS-4 to the fifth flow-chart-state FCS-5 are related to the involvement of the calculation engine CE respectively the inference calculation engine $CE_{inf}$ or the machine-learning calculation engine $CE_{ml}$ as indicated in the FIGURE 3.

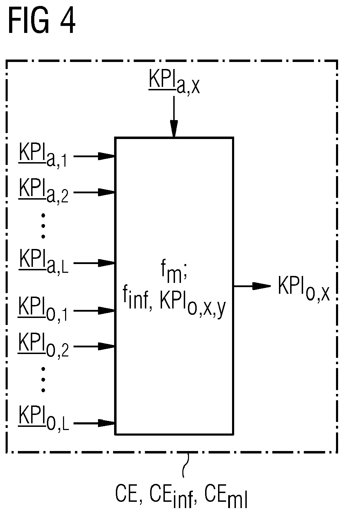

FIGURE 4 shows a principle diagram of the calculating engine CE respectively the inference calculation engine $CE_{inf}$ or the machine-learning calculation engine $CE_{ml}$, preferably used alternatively, as a component in the context of the performance determination. According to this depiction, based on the inputted KPI-sets $\underline{KPI}_{a,1}$, $\underline{KPI}_{a,2}$... $\underline{KPI}_{a,L}$, $\underline{KPI}_{a,x}$, $\underline{KPI}_{o,1}$, $\underline{KPI}_{o,2}$... $KPI_{o,L}$ of the L reference hybrid power plants $HPP_{r,1}$, $HPP_{r,2}$,... $HPP_{r,L}$ and the KPI-set $\underline{KPI}_{a,x}$ of the hybrid power plant $HPP_x$, either the calculating engine CE predicts or estimates the at least one operation-related key performance indicator $KPI_{o,x}$ for the hybrid power plant $HPP_x$ by training the mapping function $f_m$ or the inference calculation engine $CE_{inf}$, preferably used, predicts or estimates the at least one operation-related key performance indicator $KPI_{o,x}$ for the hybrid power plant $HPP_x$ by training the linear analytical inference function $\mathbf{f_{infKPI_{o,x,y}}}$.

FIGURE 5 shows with reference to the second flow-chart-state FCS-2 with the process step 2. Of the FIGURE 3 a mode of operation of the "key performance indicator"-generator KPIG as the component in the context of the performance determination.

So, in an initial operation-mode OPM-0 the "key performance indicator"-generator KPIG accesses accordingly the relevant KPI-data of the key performance indicator provisions KPIP (cf. FIGURES 1 and 2).

In a subsequent first operation-mode OPM-1 a KPIG-Input is based on the KPI-data of the database DB according to a structure and operation mode of an i-th reference hybrid power plants $HPP_{r,i}$ with i= 1...L and $L \in \mathbb{N}$,

whereas in a second operation-mode OPM-2 a further KPIG-Input is based on the KPI-data of the database DB according to a structure and operation mode of the hybrid power plant $HPP_x$.

In the following the "key performance indicator"-generator KPIG searches by comparison the KPI-data inputted for each L reference hybrid power plants $HPP_{r,i}$ with i= 1...L and $L \in \mathbb{N}$ on one side and the KPI-data inputted for the hybrid power plant $HPP_x$ on the other according to both operation-modes OPM-1, OPM-2 and for i= 1...L with $L \in \mathbb{N}$.

This leads first of all to a third operation-mode OPM-3, in which the "key performance indicator"-generator KPIG does the comparison such that if the i-th reference hybrid power plants $HPP_{r,i}$ has renewable power generation of the same type as the hybrid power plant $HPP_x$, the i-th reference hybrid power plants $HPP_{r,i}$ is selected.

Then in a fourth operation-mode OPM-4 the "key performance indicator"-generator KPIG does the comparison such that if the i-th reference hybrid power plants $HPP_{r,i}$ and the hybrid power plant $HPP_x$ have conventional power generation, e.g. diesel or gas generators, in the same operation mode, the i-th reference hybrid power plants $HPP_{r,i}$ is selected.

Furthermore, in a fifth operation-mode OPM-5 the "key performance indicator"-generator KPIG does the comparison such that if the i-th reference hybrid power plants $HPP_{r,i}$ and the hybrid power plant $HPP_x$ have batteries, the i-th reference hybrid power plants $HPP_{r,i}$ is selected.

At the end, in a sixth first operation-mode OPM-6 a KPIG-Output is given by a number k of the reference hybrid power plants $HPP_{r,i}$ selected from the database DB according with $1 \leq k \leq L$.

## Claims

1. Method for determining a performance of a hybrid power plant ($HPP_x$), which is comparable to a number L of reference hybrid power plants ($HPP_{r,1}$, $HPP_{r,2}$,... $HPP_{r,L}$) already being in operation, by

   **a)** calculating operation-related key performance indicators ($KPI_o$) for each reference hybrid power plant of the L reference hybrid power plants ($HPP_{r,1}$, $HPP_{r,2}$,... $HPP_{r,L}$) and based either on measurement data (MMD) or on measurement data (MD) and metadata (MD) thereof of each power plant as a first type of key performance indicator,

   **b)** storing a first set of calculated, operation-related key performance indicators ($\underline{KPI_{o,1}}$) for a first reference hybrid power plant ($HPP_{r,1}$), a second set of calculated, operation-related key performance indicators ($\underline{KPI_{o,2}}$) for a second reference hybrid power plant ($HPP_{r,2}$), etc. and a L-th set of calculated, operation-related key performance indicators ($\underline{KPI_{o,L}}$) for a L-th reference hybrid power plant ($HPP_{r,L}$), wherein each set of the calculated, operation-related key performance indicators ($\underline{KPI_{o,1}}, \underline{KPI_{o,2}},... \underline{KPI_{o,L}}$) contains a number Y of operation-related key performance indicators ($KPI_o$) with $1 \leq Y \leq n$ and neN,

   **c)** determining a-priori key performance indicators ($KPI_a$) for each reference hybrid power plant of the L reference hybrid power plants ($HPP_{r,1}$, $HPP_{r,2}$,... $HPP_{r,L}$) and for the hybrid power plant ($HPP_x$) each based on power plant data (PPD) related to at least one of plant environment, plant structure, power plant attributes and plant components as a second type of key performance indicator,

   **d)** storing a first set of determined, a-priori key performance indicators ($\underline{KPI_{a,1}}$) for the first reference hybrid power plant ($HPP_{r,1}$), a second set of determined, a-priori key performance indicators ($\underline{KPI_{a,2}}$) for a second reference hybrid power plant ($HPP_{r,2}$), etc. and a L-th set of determined, a-priori key performance indicators ($\underline{KPI_{a,L}}$) for a L-th reference hybrid power plant ($HPP_{r,L}$) as well as a set of determined, a-priori key performance indicators ($\underline{KPI_{a,x}}$) for the hybrid power plant ($HPP_x$), wherein each set of the determined, a-priori key performance indicators ($\underline{KPI_{a,1}}, \underline{KPI_{a,2}},... \underline{KPI_{a,L}}, \underline{KPI_{a,x}}$) contains a number Z of a-priori key performance indicators ($KPI_a$) with $1 \leq Z \leq n$ and neN,

   **characterized by**

   the following steps for the performance determination of the hybrid power plant ($HPP_x$), which is either also in operation or at least one of designed, deployed and commissioned for operation:

   e) inputting the stored sets of determined, a priori-key performance indicators ($\underline{KPI_{a,1}}, \underline{KPI_{a,2}}... \underline{KPI_{a,L}}, \underline{KPI_{a,x}}$) and the stored sets of calculated, operation-related key performance indicators ($\underline{KPI_{o,1}}, \underline{KPI_{o,2}}... \underline{KPI_{o,L}}$) to a calculation engine (CE) to predict or to estimate at least one operation-related key performance indicator ($KPI_{o,x}$),

   f) training a mapping function ($f_m$) with the inputted KPI-sets ($\underline{KPI_{a,1}}, \underline{KPI_{a,2}}... \underline{KPI_{a,L}}, \underline{KPI_{a,x}}, \underline{KPI_{o,1}}, \underline{KPI_{o,2}}... \underline{KPI_{o,L}}$) as arguments of the mapping function (fm) by the calculation engine (CE) such that the result of the training is the at least one predicted or estimated operation-related key performance indicator ($KPI_{o,x}$),

   g) deriving from the at least one predicted or estimated operation-related key performance indicator ($KPI_{o,x}$) a performance size (PS) or performance value (PV) of the hybrid power plant ($HPP_x$) .

2. Method according to claim 1, **characterized in that** the calculation engine (CE) is used as an inference calculation engine ($CE_{inf}$) to predict the at least one operation-related key performance indicator ($KPI_{o,x}$) by training a linear analytical inference function

**$f_{inf,KPI_{o,x,y}}$**

for a y-th operation-related $KPI_{o,x,y}$ for each of the Y operation-related key performance indicators ($KPI_o$)

$$f_{inf,KPI_{o,x,y}}\left(KPI_{a,1}, KPI_{a,2}, \dots KPI_{a,L}, KPI_{a,x}, KPI_{o,1}, KPI_{o,2}, \dots KPI_{o,L,}\right) = \sum_{i=1}^{L}\sum_{j=1}^{Y}\sum_{k=1}^{Z} a_{yjk} e^{-\left(KPI_{a,i,k}-KPI_{a,x,k}\right)^2} KPI_{o,i,j}$$

wherein

- $a_{yjk}$ are parameters of the linear analytical inference function $f_{inf,KPI_{o,x,y}}$,
- to train the linear analytical inference function $f_{inf,KPI_{o,x,y}}$ state of the art solvers is used to minimize the deviation between the predicted $KPI_{o,x,y}$, and the measured ones,
- a number L-1 of the stored, reference hybrid power plants ($HPP_{r,1}$, $HPP_{r,2}$,... $HPP_{r,L}$) are used as inputs,
- from the remaining L-th plant of the stored, reference hybrid power plants ($HPP_{r,1}$, $HPP_{r,2}$,... $HPP_{r,L}$) an a-priori key performance indicator $\underline{KPI_{a,L}}$ is used as input and an operation-related key performance indicator $KPI_{o,L,y}$ as expected value,
- a difference is defined as

$$err_{KPI_{o,L,y}} = KPI_{o,L,y} - f_{inf,KPI_{o,L,y}}\left(KPI_{a,1}, KPI_{a,2}, \dots KPI_{a,L}, KPI_{o,1}, KPI_{o,2}, \dots KPI_{o,L-1}\right)$$

- an optimization problem is solved to estimate the parameters $a_{yjk}$ for the y-th operation-related key performance $KPI_{o,L,y}$

$$\underset{a_{yjk}}{argmin} \sum_{n=1}^{N} (err_{KPI_{o,L,y}}))2$$

- the same procedure is repeated to estimate **$a_{yjk}$** for all operation-related key performance indicators ($KPI_o$).

3. Method according to claim 1, **characterized in that** the calculation engine (CE) is used as an machine-learning calculation engine ($CE_{ml}$) to estimate the at least one operation-related key performance indicator ($KPI_{o,x}$) by training the mapping function ($f_m$) without the need to specify a structure of the mapping function (fm), wherein a subset of the reference hybrid power plants ($HPP_{r,1}$, $HPP_{r,2}$,... $HPP_{r,L}$) are used for the training, while the remaining ones of the reference hybrid power plants ($HPP_{r,1}$, $HPP_{r,2}$,... $HPP_{r,L}$) are used for validation.

4. Method according to one of the claims 1 to 3, **characterized in that**
   the number of the inputted KPI-sets ($\underline{KPI_{a,1}}$, $\underline{KPI_{a,2}}$... $\underline{KPI_{a,L}}$, $\underline{KPI_{a,x}}$, $\underline{KPI_{o,1}}$, $\underline{KPI_{o,2}}$... $\underline{KPI_{o,L}}$) is reduced by selecting a subset of the stored KPI-sets ($\underline{KPI_{a,1}}$, $\underline{KPI_{a,2}}$... $\underline{KPI_{a,L}}$, $KPI_{o,1}$, $\underline{KPI_{o,2}}$... $\underline{KPI_{o,L}}$) of those reference hybrid power plants ($HPP_{r,1}$, $HPP_{r,2}$,... $HPP_{r,L}$), which match best with or are similar to the hybrid power plant ($HPP_x$).

5. Method according to one of the claims 1 to 4, **characterized in that**
   the performance size (PS) or the performance value (PV) of the hybrid power plant ($HPP_x$) is used to apply a setpoint (SP) to the hybrid power plant ($HPP_x$) or is used to assess the hybrid power plant ($HPP_x$) by a parameter (PM).

6. Computer-implemented tool (CIT), in particular an Application Software <App>, for determining a performance of a hybrid power plant ($HPP_x$) being comparable to a number L of reference hybrid power plants ($HPP_{r,1}$, $HPP_{r,2}$,... $HPP_{r,L}$) already being in operation, wherein

   a) operation-related key performance indicators ($KPI_o$) are calculated as a first type of key performance indicator for each reference hybrid power plant of the L reference hybrid power plants ($HPP_{r,1}$, $HPP_{r,2}$,... $HPP_{r,L}$) and based either on measurement data (MMD) or on measurement data (MMD) and metadata (MD) thereof of each power plant,

b) a first set of calculated, operation-related key performance indicators $(\underline{KPI}_{o,1})$ is stored for a first reference hybrid power plant $(HPP_{r,1})$, a second set of calculated, operation-related key performance indicators $(\underline{KPI}_{o,2})$ is stored for a second reference hybrid power plant $(HPP_{r,2})$, etc. and a L-th set of calculated, operation-related key performance indicators $(\underline{KPI}_{o,L})$ is stored for a L-th reference hybrid power plant $(HPP_{r,L})$, wherein each set of the calculated, operation-related key performance indicators $(\underline{KPI}_{o,1}, \underline{KPI}_{o,2}... \underline{KPI}_{o,L})$ contains a number Y of operation-related key performance indicators $(KPI_o)$ with $1 \leq Y \leq n$ and $n \epsilon N$,

c) a-priori key performance indicators $(KPI_a)$ are determined as a second type of key performance indicator for each reference hybrid power plant of the L reference hybrid power plants $(HPP_{r,1}, HPP_{r,2},... HPP_{r,L})$ and the hybrid power plant $(HPP_x)$ each based on power plant data (PPD) related to at least one of plant environment, plant structure, power plant attributes and plant components,

d) a first set of determined, a-priori key performance indicators $(\underline{KPI}_{a,1})$ is stored for the first reference hybrid power plant $(HPP_{r,1})$, a second set of determined, a-priori key performance indicators $(\underline{KPI}_{a,2})$ is stored for a second reference hybrid power plant $(HPP_{r,2})$, etc. and a L-th set of determined, a-priori key performance indicators $(\underline{KPI}_{a,L})$ is stored for a L-th reference hybrid power plant $(HPP_{r,L})$ as well as a set of determined, a-priori key performance indicators $(\underline{KPI}_{a,x})$ is stored for the hybrid power plant $(HPP_x)$, wherein each set of the determined, a-priori key performance indicators $(\underline{KPI}_{a,1}, \underline{KPI}_{a,2}... \underline{KPI}_{a,L}, \underline{KPI}_{a,x})$ contains a number Z of a-priori key performance indicators $(KPI_a)$ with $1 \leq Z \leq n$ and $n \epsilon N$,

**characterized by**

a non-transitory, processor-readable storage medium (STM) having processor-readable program-instructions of a program module (PGM) for determining the performance of the hybrid power plant $(HPP_x)$, which is either also in operation or at least one of designed, deployed and commissioned for operation, stored in the non-transitory, processor-readable storage medium (STM) and a processor (PRC) connected with the storage medium (STM) executing the processor-readable program-instructions of the program module (PGM) to determine the hybrid power plant performance, wherein the program module (PGM) and the processor (PRC) form a calculation engine (CE) such that:

e) at least one operation-related key performance indicator $(KPI_{o,x})$ is predicted or estimated based on a calculation engine input of the stored sets of determined, a priori-key performance indicators $(\underline{KPI}_{a,1}, \underline{KPI}_{a,2}... \underline{KPI}_{a,L}, \underline{KPI}_{a,x})$ and the stored sets of calculated, operation-related key performance indicators $(\underline{KPI}_{o,1}, \underline{KPI}_{o,2}... \underline{KPI}_{o,L})$,

f) the at least one operation-related key performance indicator $(KPI_{o,x})$ is predicted or estimated by training a mapping function $(f_m)$ with the inputted KPI-sets $(\underline{KPI}_{a,1}, \underline{KPI}_{a,2}... \underline{KPI}_{a,L}, \underline{KPI}_{a,x}, \underline{KPI}_{o,1}, \underline{KPI}_{o,2}... \underline{KPI}_{o,L})$ as arguments of the mapping function (fm),

g) a performance size (PS) or performance value (PV) of the hybrid power plant $(HPP_x)$ is derived from the at least one predicted or estimated operation-related key performance indicator $(KPI_{o,x})$.

7. Computer-implemented tool (CIT) according to claim 6,
   **characterized in that**
   the calculation engine (CE) is designed as an inference calculation engine $(CE_{inf})$ to predict the at least one operation-related key performance indicator $(KPI_{o,x})$ by training a linear analytical inference function

   $f_{inf,KPI_{o,x,y}}$
   for a y-th operation-related $KPI_{o,x,y}$ for each of the Y operation-related key performance indicators $(KPI_o)$

$$f_{inf,KPI_{o,x,y}}\left(KPI_{a,1}, KPI_{a,2}, ... \ KPI_{a,L}, KPI_{a,x}, KPI_{o,1}, KPI_{o,2}, ... \ KPI_{o,L},\right) = \sum_{i=1}^{L}\sum_{j=1}^{Y}\sum_{k=1}^{Z} a_{yjk} e^{-\left(KPI_{a,i,k} - KPI_{a,x,k}\right)^2} KPI_{o,i,j}$$

wherein

- $a_{yjk}$ are parameters of the linear analytical inference function $f_{inf,KPI_{o,x,y}}$,
- to train the linear analytical inference function $f_{inf,KPI_{o,x,y}}$ state of the art solvers is used to minimize the deviation between the predicted $KPI_{o,x,y}$, and the measured ones,
- a number L-1 of the stored, reference hybrid power plants $(HPP_{r,1}, HPP_{r,2},... HPP_{r,L})$ are used as inputs,
- from the remaining L-th plant of the stored, reference hybrid power plants $(HPP_{r,1}, HPP_{r,2},... HPP_{r,L})$ an a-priori key performance indicator $\underline{KPI}_{a,L}$ is used as input and an operation-related key performance indicator $KPI_{o,L,y}$ as expected value,
- a difference is defined as

$$\mathrm{err}_{\mathrm{KPI}_{o,L,y}} = \mathrm{KPI}_{o,L,y} - f_{\inf,\mathrm{KPI}_{o,L,y}}\left(\mathrm{KPI}_{a,1}, \mathrm{KPI}_{a,2}, \ldots \mathrm{KPI}_{a,L}, \mathrm{KPI}_{o,1}, \mathrm{KPI}_{o,2}, \ldots \mathrm{KPI}_{o,L-1}\right)$$

- an optimization problem is solved to estimate the parameters $a_{yjk}$ for the y-th operation-related key performance $\mathrm{KPI}_{o,L,y}$

$$\operatorname*{argmin}_{a_{yjk}} \sum_{n=1}^{N} (\mathrm{err}_{\mathrm{KPI}_{o,L,y}}))2$$

- the same procedure is repeated to estimate $\boldsymbol{a_{yjk}}$ for all operation-related key performance indicators ($\mathrm{KPI}_o$).

8. Computer-implemented tool (CIT) according to claim 6,
   **characterized in that**
   the calculation engine (CE) is designed as an machine-learning calculation engine ($\mathrm{CE}_{ml}$) to estimate the at least one operation-related key performance indicator ($\mathrm{KPI}_{o,x}$) by training the mapping function (fm) without the need to specify a structure of the mapping function (fm), a subset of the reference hybrid power plants ($\mathrm{HPP}_{r,1}$, $\mathrm{HPP}_{r,2}$,... $\mathrm{HPP}_{r,L}$) are used for the training, while the remaining ones of the reference hybrid power plants ($\mathrm{HPP}_{r,1}$, $\mathrm{HPP}_{r,2}$,... $\mathrm{HPP}_{r,L}$) are used for validation.

9. Computer-implemented tool (CIT) according to one of the claims 6 to 8, **characterized in that**
   the number of the inputted KPI-sets ($\underline{\mathrm{KPI}_{a,1}}$, $\underline{\mathrm{KPI}_{a,2}}$... $\underline{\mathrm{KPI}_{a,L}}$, $\underline{\mathrm{KPI}_{a,x}}$, $\underline{\mathrm{KPI}_{o,1}}$, $\underline{\mathrm{KPI}_{o,2}}$... $\underline{\mathrm{KPI}_{o,L}}$) is reduced by selecting a subset of the stored KPI-sets ($\underline{\mathrm{KPI}_{a,1}}$, $\underline{\mathrm{KPI}_{a,2}}$... $\underline{\mathrm{KPI}_{a,L}}$, $\underline{\mathrm{KPI}_{o,1}}$, $\underline{\mathrm{KPI}_{o,2}}$... $\underline{\mathrm{KPI}_{o,L}}$) of those reference hybrid power plants ($\mathrm{HPP}_{r,1}$, $\mathrm{HPP}_{r,2}$,... $\mathrm{HPP}_{r,L}$), which match best with or are similar to the hybrid power plant ($\mathrm{HPP}_x$).

10. Computer-implemented tool (CIT) according to one of the claims 6 to 9, **characterized in that**
    the performance size (PS) or the performance value (PV) of the hybrid power plant ($\mathrm{HPP}_x$) is used to apply a setpoint (SP) to the hybrid power plant ($\mathrm{HPP}_x$) or is used to assess the hybrid power plant ($\mathrm{HPP}_x$) by a parameter (PM).

11. Power plant control device (PPCD) for determining a performance of a hybrid power plant ($\mathrm{HPP}_x$), being comparable to a number L of reference hybrid power plants ($\mathrm{HPP}_{r,1}$, $\mathrm{HPP}_{r,2}$,... $\mathrm{HPP}_{r,L}$) already being in operation, with a control unit (CU) connected to a power plant interface (PPIF) for controlling the hybrid power plants ($\mathrm{HPP}_x$, $\mathrm{HPP}_1$, $\mathrm{HPP}_2$,... $\mathrm{HPP}_L$),
    **characterized by**
    a Computer-implemented tool (CIT) according to one of the claims 6 to 10 either being implemented as a sub-unit in the control unit (CU) or forming a functional unit (FTU) with the control unit (CU), in particular such that the Computer-implemented tool (CIT) is uploadable into the control unit (CU) or forms either a cloud-based, centralized platform for the power plant control device (PPCD) or a decentralized platform for the power plant control device (PPCD), for carrying out the method according to one of the claims 1 to 5.

12. Hybrid power plant system (HPPS) including

    - a database (DB), preferably a data cloud, which on the input side is connected to

        -- a number L of reference hybrid power plants ($\mathrm{HPP}_{r,1}$, $\mathrm{HPP}_{r,2}$,... $\mathrm{HPP}_{r,L}$) already being in operation and
        -- a hybrid power plant ($\mathrm{HPP}_x$) for determining its performance being either also in operation or at least one of designed, deployed and commissioned for operation and

    - a "key performance indicator"-generator, which on an input side and on an output side is connected to the database (DB) for calculating key performance indicators of a first type of key performance indicator and for determining key performance indicators of a second type of key performance indicator,
    **characterized by**
    a power plant control device (PPCD) for determining the performance of the hybrid power plant ($\mathrm{HPP}_x$) according to claim 11, which is assigned to the database (DB) and forms a functional unit with the database (DB), the "key performance indicator"-generator (KPIG), the number L of reference hybrid power plants ($\mathrm{HPP}_{r,1}$, $\mathrm{HPP}_{r,2}$,... $\mathrm{HPP}_{r,L}$) and the hybrid power plant ($\mathrm{HPP}_x$) such that the method according to one of the claims 1 to 5 is carried out.

# FIG 1

KPIP:

$KPI_0$ ; $\underline{KPI_{0,1}}$, $\underline{KPI_{0,2}}$, ...
$\underline{KPI_{0,L}}$; $KPI_a$ ; $\underline{KPI_{a,1}}$,
$\underline{KPI_{a,2}}$, ... $\underline{KPI_{a,L}}$ ; $\underline{KPI_{a,x}}$

Power Plant Control Device

Computer - implemented Tool

STM

PGM

CIT

Storage Medium

Program Module

Control Unit

CU

PPCD

HPP$_x$

PS, PV

SP(PS, PV);
PM(PS, PV)

Hybrid Power Plant

DB

Database e.g. data cloud

$KPI_{0,x}$

PRC

Processor

PS, PV

Power Plant Inter-face

KPIG

MMD, MD, PPD

CE, CE$_{inf}$, CE$_{ml}$

PPIF

"Key Performance Indicator"-Generator

PPD

MMD, MD, PPD

MMD, MD, PPD

MMD, MD, PPD

HPPS

Reference Hybrid Power Plant

HPP$_{r,1}$

Reference Hybrid Power Plant

HPP$_{r,2}$

· · ·

Reference Hybrid Power Plant

HPP$_{r,L}$

EP 3 889 698 A1

FIG 2

EP 3 889 698 A1

# FIG 3

FCS-0 — | 0. Performance Determination of a hybrid power plant ($HPP_x$) |

FCS-1 — | 1. Collecting and storing data of measurements (MMD, MD) and/or power plant data (PPD) from reference hybrid power plants / the hybrid power plant in a measurement data base |

FCS-2 — | 2. Search for reference hybrid power plants with similar operating conditions and/or similar structure in comparison to the hybrid power plant and select the plants and the corresponding data being searched for (cf. FIGURE 5) |

DB;
KPIG

FCS-3 — | 2./3. Calculating a first type of key performance indicator ($KPI_0$) for all or the searched and selected reference hybrid power plants and determing of a second type of key performance indicator ($KPI_a$) for the hybrid power plant as well as for all or the searched and selected reference hybrid power plants |

FCS-4 — | 3./4. The calculated / determined key performance indicators of both types are used to predict or estimate at least one key performance indicator ($KPI_{0,x}$) of the first type for the hybrid power plant (HPPx) |

CE,
$CE_{inf}$,
$CE_{ml}$

FCS-5 — | 4./5. Deriving from the predicted or estimated key performance indicator a performance size (PS) or a performance value (PV) to apply a setpoint (SP) to the hybrid power plant or to assess the hybrid power plant by a parameter (PM) e.g. a guarantee |

# FIG 4

# FIG 5

Database ⌐—DB

↓⌐KPI-data of KPIP          KPIG          OPM-0 ↙

**OPM-1**

KPIG-Input: KPI-data of the database according to a structure and operation mode of an i-th reference hybrid power plant $HPP_{r,i}$ with i=1...L and L∈N

**OPM-2**

KPIG-Input: KPI-data of the database according to a structure and operation mode of a hybrid power plant $HPP_x$

**OPM-3**

For i=1...L with L∈N

If $HPP_{r,i}$ has renewable power generation of the same type as $HPP_x$ → select $HPP_{r,i}$

**OPM-4**

If $HPP_{r,i}$ and $HPP_x$ have conventional power generation (e.g. diesel or gas generators) in the same operating mode → select $HPP_{r,i}$

**OPM-5**

If $HPP_{r,i}$ and $HPP_x$ have batteries → select $HPP_{r,i}$

**OPM-6**

KPIG-Output: a number k of the reference hybrid power plants selected from the database with $1 \leq k \leq L$

Europäisches
Patentamt

European
Patent Office

Office européen
des brevets

## EUROPEAN SEARCH REPORT

**Application Number**

EP 20 16 6725

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/083933 A1 (SUBBU RAJESH VENKAT [US] ET AL) 5 April 2012 (2012-04-05) * paragraphs [0001], [0004] - [0006] * * paragraphs [0016] - [0020] * * paragraphs [0038] - [0046] * * figure 4 * | 1-12 | INV. G05B17/02 G06F30/00 G06Q50/06 |
| A | WO 2015/078494 A1 (SIEMENS AG [DE]) 4 June 2015 (2015-06-04) * page 1, lines 5-8 * * page 3, lines 25-31 * * page 5, lines 11-21 * | 1-12 | |
| A | FR 3 042 028 A1 (ELECTRICITE DE FRANCE [FR]) 7 April 2017 (2017-04-07) * page 1, lines 4,5 * * page 6, lines 19,20 * * page 7, lines 21-31 * * page 8, lines 9-11 * * page 10, lines 7-10 * * page 14, lines 29-32 * * page 15, lines 2-4 * | 1-12 | |

| | |
|---|---|
| | TECHNICAL FIELDS SEARCHED (IPC) |
| | G05B G06F G06Q |

The present search report has been drawn up for all claims

| Place of search | Date of completion of the search | Examiner |
|---|---|---|
| The Hague | 31 August 2020 | Dörre, Thorsten |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 20 16 6725

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2020

| Patent document cited in search report | | Publication date | Patent family member(s) | | Publication date |
|---|---|---|---|---|---|
| US 2012083933 | A1 | 05-04-2012 | CN | 102446301 A | 09-05-2012 |
| | | | EP | 2437206 A1 | 04-04-2012 |
| | | | JP | 6025237 B2 | 16-11-2016 |
| | | | JP | 2012079304 A | 19-04-2012 |
| | | | US | 2012083933 A1 | 05-04-2012 |
| WO 2015078494 | A1 | 04-06-2015 | NONE | | |
| FR 3042028 | A1 | 07-04-2017 | FR | 3042028 A1 | 07-04-2017 |
| | | | WO | 2017055782 A1 | 06-04-2017 |

EPO FORM P0459

For more details about this annex : see Official Journal of the European Patent Office, No. 12/82